# EUROPEAN PATENT SPECIFICATION

(11) **EP 2 740 337 B1**
(45) Date of publication and mention of the grant of the patent: **08.03.2017**
(21) Application number: 11870254.7
(22) Date of filing: 04.08.2011
(51) Int. Cl.: H05K 7/20

(54) **METHOD AND DEVICE FOR DETECTING CLOGGING OF A FILTER**
VERFAHREN UND VORRICHTUNG ZUR ERKENNUNG DER VERSTOPFUNG EINES FILTERS
PROCÉDÉ ET DISPOSITIF DE DÉTECTION D'UNE OBSTRUCTION D'UN FILTRE

(43) Date of publication of application: 11.06.2014
(73) Proprietor: Telefonaktiebolaget LM Ericsson (publ), 164 83 Stockholm (SE)
(72) Inventor: HE, Qingqing, Beijing 102209 (CN); JIN, Jin, Beijing 100102 (CN)
(74) Representative: Lind, Robert
(86) International application number: PCT/CN2011/001282
(87) International publication number: WO 2013/016845

(56) References cited:
- EP-A1- 2 141 038
- CN-A- 101 004 544
- CN-A- 101 368 938
- CN-A- 101 813 708
- JP-A- S60 147 213
- JP-A- 2000 070 638
- US-B2- 7 261 762

## Description

### TECHNICAL FIELD

The present invention generally relates to a filter, particularly to a method and device for detecting clogging of a filter.

### BACKGROUND

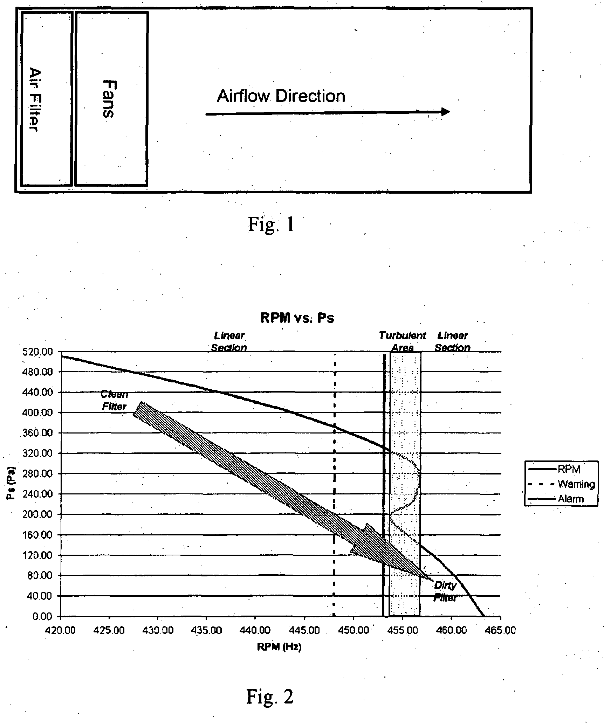

Today, most of electronic apparatuses including telecommunication equipments are equipped with fans for cooling their heat generating components. Fig. 1 illustrates a schematic view of an electronic apparatus equipped with fans. When the fans operate, dust enters into the apparatuses along with air flow and may be harmful to the components inside. As shown in Fig. 1, an air/dust filter is thus typically provided at the air inlet of the apparatuses and close to the fans to prevent dust from entering the apparatuses.

Nevertheless, dust accumulates in the filter and eventually clogs the filter. Clogging of a filter may prevent the air flow from entering into the apparatuses and cause the components overheat. For some apparatus such as telecommunication equipments which are required to have highly reliable, 24/7 operation, it is preferred that filter clogging is detectable. For example, filter clogging detectable is an optional requirement of Network Equipment-Building System (NEBS).

Some methods for detecting filter clogging have been discussed in the prior art. However, the detection accuracy is not satisfying. It is needed to provide a filter clogging detection method and device with improved accuracy. JP 360147213 discloses a device for detecting clogging of a filter comprising a fan speed sensor, a controller to obtain a threshold and to compare the fan speed with the threshold, and an alarm to sound if the fan speed exceeds the threshold. JP 2000 070638 discloses the use of ambient temperature to determine a threshold.

### SUMMARY

Therefore, it is an object to solve at least one of the above-mentioned problems.

According to an aspect of the invention, a method for detecting clogging of a filter is provided. The method comprises obtaining a plurality of ambient parameters, obtaining a plurality of thresholds respectively associated with each ambient parameter, and obtaining a speed of a fan which is located near the filter. The method further comprises comparing the fan speed with the thresholds and outputting an alarm signal indicative of the clogging if the fan speed exceeds each of the thresholds. The plurality of ambient parameters comprises two or more of ambient temperature, atmosphere pressure and supply voltage.

Obtaining the speed of the fan may comprise obtaining an average value of the fan speed over a predetermined time period. The fan speed may be represented by Revolutions Per Minute (RPM). Obtaining a threshold associated with the ambient parameter may comprise retrieving a lookup table including predetermined thresholds for a plurality of ambient parameters. The predetermined threshold for one of the plurality of ambient parameters may be derived from the speed of the fan cooperative with a partly clogged filter under the one of the plurality of ambient parameters.

Comparing the fan speed with the threshold may comprise comparing the fan speed with the threshold for more than once, and outputting the alarm signal indicative of the clogging may comprise outputting the alarm signal indicative of the clogging only if the fan speed exceeds the threshold in each of the more than once comparisons.

According to another aspect of the invention, a device for detecting clogging of a filter is provided. The device comprises a parameter sensor adapted to obtain a plurality of ambient parameters and a fan speed sensor adapted to obtain a speed of a fan which is located near the filter. The device further comprises a controller adapted to obtain thresholds associated with each of the plurality of ambient parameters, compare the fan speed with teach threshold, and output an alarm signal indicative of the clogging if the fan speed exceeds each threshold. The plurality of ambient parameters comprises two or more of ambient temperature, atmosphere pressure and supply voltage.

The fan speed sensor may be adapted to obtain an average value of the fan speed over a predetermined time period. The fan speed may be represented by RPM. The controller is further adapted to compare the fan speed with the threshold for more than once. According to still another aspect of the invention, a filter system comprising a dust filter, a fan located near the filter and a device for detecting clogging of the filter is provided.

### BRIEF DESCRIPTION OF THE DRAWINGS

The invention will be described in detail by reference to the following drawings, in which:
Fig. 1 illustrates a schematic view of an electronic apparatus equipped with fans;
Fig. 2 is a curve from wind tunnel tests illustrating relationship between fan speed and back pressure;
Fig. 3 illustrates a flowchart of a method for detecting clogging of a filter in accordance with an embodiment of the invention;
Fig. 4 shows a block diagram of a filter clogging detection device 500 in accordance with an embodiment of the invention; and
Fig. 5 shows a flowchart of the fan calibration process in accordance with an embodiment of the invention.

### DETAILED DESCRIPTION

Embodiments of the present invention will be described more fully hereinafter with reference to the accompanying drawings, in which embodiments of the invention are shown. This invention may, however, be embodied in many different forms and should not be construed as limited to the embodiments set forth herein. Like numbers refer to like elements throughout. The terminology used herein is for the purpose of describing particular embodiments only and is not intended to be limiting of the invention. As used herein, the singular forms "a", "an" and "the" are intended to include the plural forms as well, unless the context clearly indicates otherwise. It will also be understood that the term "filter" is usually the dust filter or air filter, but may have different names in other apparatuses. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

The present invention is described below with reference to block diagrams and/or flowchart illustrations of methods, apparatus (systems) and/or computer program products according to embodiments of the invention. It is understood that blocks of the block diagrams and/or flowchart illustrations, and combinations of blocks in the block diagrams and/or flowchart illustrations, can be implemented by computer program instructions. These computer program instructions may be provided to a processor of a general purpose computer, special purpose computer, and/or other programmable data processing apparatus to produce a machine, such that the instructions, which execute via the processor of the computer and/or other programmable data processing apparatus, create means for implementing the functions/acts specified in the block diagrams and/or flowchart block or blocks.

Accordingly, the present invention may be embodied in hardware and/or in software (including firmware, resident software, micro-code, etc.). Furthermore, the present invention may take the form of a computer program product on a computer-usable or computer-readable storage medium having computer-usable or computer-readable program code embodied in the medium for use by or in connection with an instruction execution system. In the context of this document, a computer-usable or computer-readable medium may be any medium that can contain, store, communicate, propagate, or transport the program for use by or in connection with the instruction execution system, apparatus, or device.

Embodiments of the invention will be described below with reference to the drawings.

The inventor found when the filter is clogged, the air flow is retarded, which result in a pressure drop. For a fan which is located near the filter, the drop in back pressure in turn has an impact on the fan speed Therefore, the fan speed can be monitored to determine whether or not the filter is clogged.

Fig. 2 is a curve from wind tunnel tests illustrating relationship between of fan speed and back pressure.

The fan speed is represented by Revolutions Per Minute (RPM) in Fig. 2, though it can be represented in other manners. When the fan is provided with constant Pulse-Width Modulation (PWM) signal, the curve in Fig. 2 shows that RPM increases as back pressure drops except for a so-called turbulent area. The other two sections are quasi-linear and can be used for filter clogging detection. As shown in Fig. 2, a relatively low RPM corresponds to a relative high back pressure, which indicates a clean filter; in contrast, a relatively high RPM corresponds to a relative low back pressure, which indicates a dirty filter. A first threshold is set to a RPM value of about 448Hz (denoted by dashed line). If the detected RPM exceeds the first threshold, it is determined that the filter is clogged and a warning signal can be output to remind the user or operator of replacement of the filter. In addition, a second threshold may be set to a higher RPM value of about 453Hz (denoted by real line). If the detected RPM exceeds the second threshold, it is determined that the filter is even seriously clogged and a more urgent warning signal (denoted as alarm in Fig. 2) can be output.

With the alarm or warning, the user or operator will know the time when the filter needs to be replaced, and the electronic apparatus is protected.

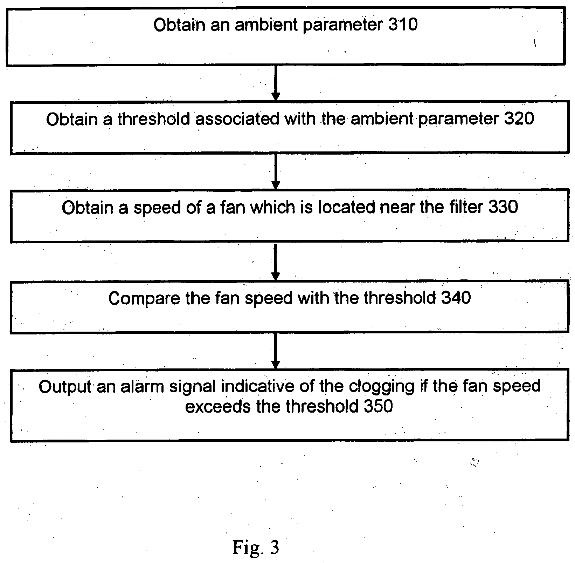

Fig. 3 illustrates a flowchart of a method for detecting clogging of a filter in accordance with an embodiment of the invention.

The inventor realizes that the accuracy of clogging detection is impacted by ambient parameter/factor(s). In order to improve the accuracy of clogging detection, it is proposed to take into account at least one ambient parameter/factor. The ambient parameter may include at least one of ambient temperature, atmosphere pressure and supply voltage. For example, the fan speed, such as RPM, varies when ambient temperature changes. Fixed alarm threshold for all ambient temperatures may cause false alarm and the user or operator may not be able to replace the filter at the right time. On one hand, replacing the filter too frequently would increase cost and waste time. On the other hand, if the filter is replaced too late, the electronic apparatus might be harmed by dust.

In step 310, an ambient parameter such as ambient temperature, atmosphere pressure and supply voltage, etc. is obtained. A threshold associated with the ambient parameter is obtained in step 320. Obtaining the threshold associated with the ambient parameter may comprise retrieving a lookup table including predetermined thresholds for a plurality of ambient parameters. A speed of a fan which is located near the filter is obtained in step 330. The fan speed may be represented by RPM. Then the fan speed is compared with the threshold in step 340. In step 350, an alarm signal indicative of the clogging is output if the fan speed exceeds the threshold. The predetermined threshold for one of the plurality of ambient parameters may be derived from a calibration process. For example, during the calibration process, the RPM of the fan cooperative with a partly clogged filter under the one of the plurality of ambient parameters can be recorded as the threshold for that ambient parameter.

By using a dynamic threshold which best suits the ambient parameter, such as ambient temperature, atmosphere pressure and/or supply voltage, instead of a fixed threshold, the detection accuracy and reliability will be improved and the possibility of false alarm will be reduced or eliminated. As a result, the user or operator will be notified of replacing the filter at the right time.

Obtaining the speed of the fan may comprise obtaining an average value of the fan speed over a predetermined time period. Thus, the accuracy may be even improved. To further lower the possibility of false alarm, the comparison between the fan speed and the threshold can be performed for more than once. The alarm signal will be output only if the fan speed exceeds the threshold in each of the more than once comparisons.

More than one ambient parameter can be taken into account when obtaining the threshold. For example, a threshold which best suits the ambient temperature and atmosphere pressure can be obtained or selected.

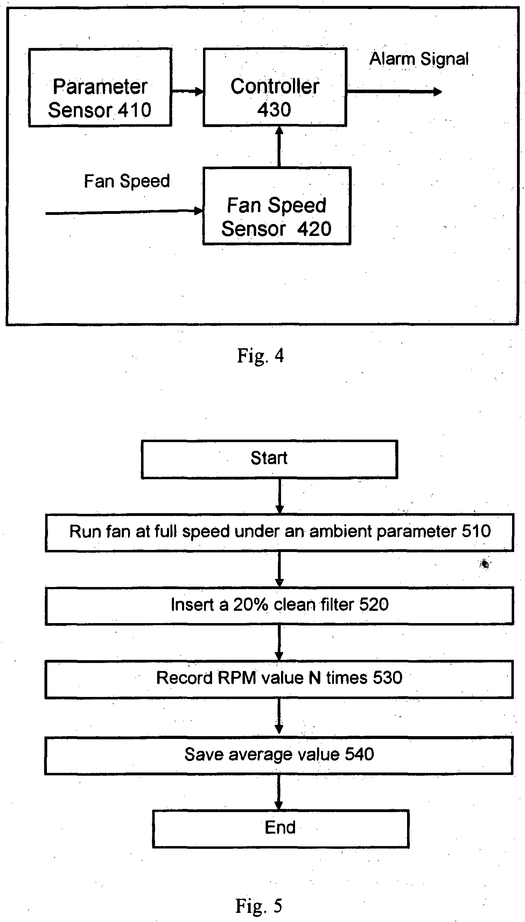

Fig. 4 shows a block diagram of a filter clogging detection device 500 in accordance with an embodiment of the invention.

As shown in Fig. 4, the device 500 includes a parameter sensor 510 for obtaining an ambient parameter and a fan speed sensor 520 for obtaining a speed of a fan which is located near the filter. The ambient parameter may include ambient temperature, atmosphere pressure and supply voltage, and the parameter sensor 510 may be a temperature sensor, an atmosphere pressure sensor or supply voltage sensor. The fan speed sensor may obtain an average value of the fan speed over a predetermined time period. The device 500 further includes a controller 530, which is adapted to obtain a threshold associated with the ambient parameter, compare the fan speed with the threshold, and output an alarm signal indicative of the clogging if the fan speed exceeds the threshold. The controller 530 may compare the fan speed with the threshold for more than once in order to lower the possibility of false alarm.

Fig. 5 shows a flowchart of the fan calibration process in accordance with an embodiment of the invention.

In step 510, the fan is run at full speed under an ambient parameter such as a ambient temperature Then a partly clogged filter, e.g. a filter of 20% clean (80% clogged) is inserted at step 520. The RPM value are recorded N times (N>1) at step 530, and the average RPM value is saved as the threshold for that ambient parameter. Suppose an 80% clogged filter is used in the calibration process, the filter clogging detection device will detect the filter in the electronic apparatus as clogged if it is 80% clogged.

It should be noted that there is no strict sequence for steps in the embodiments above. For example, step 310 and 320 can take place at the same time or before step 330.

While the preferred embodiments of the present invention have been illustrated and described, it will be understood by those skilled in the art that various changes and modifications may be made, and equivalents may be substituted for elements thereof without departing from the true scope of the present invention. In addition, many modifications may be made to adapt to a particular situation and the teaching of the present invention without departing from its central scope. Therefore it is intended that the present invention not be limited to the particular embodiment disclosed as the best mode contemplated for carrying out the present invention, but that the present invention include all embodiments falling within the scope of the appended claims.

## Claims

1. A method for detecting clogging of a filter,
comprising: obtaining (310) a plurality of ambient
parameters;
for each of the plurality of ambient parameters:
obtaining (320) a plurality of thresholds respectively associated with each ambient parameter;
obtaining (330) a speed of a fan which is located near the filter;
comparing (340) the fan speed with the thresholds; and
outputting (350) an alarm signal indicative of the clogging if the fan speed exceeds each of the thresholds,
wherein the plurality of ambient parameters comprises two or more of:
ambient
temperature, atmosphere pressure and supply voltage.

2. The method of claim 1, wherein obtaining the speed of the fan comprises obtaining an average value of the fan speed over a predetermined time period.

3. The method of claim 1 or 2, wherein the fan speed is represented by Revolutions Per Minute (RPM).

4. The method of claim 1 or 2, wherein obtaining a threshold associated with the ambient parameter comprises retrieving a lookup table including predetermined thresholds for a plurality of ambient parameters.

5. The method of claim 4, wherein the predetermined threshold for one of the plurality of ambient parameters is derived from the speed of the fan cooperative with a partly clogged filter under the one of the plurality of ambient parameters.

6. A device for detecting clogging of a filter, comprising:
a plurality of parameter sensors (410), each sensor adapted to obtain a respective one of a plurality of ambient parameters;
a fan speed sensor (420) adapted to obtain a speed of a fan which is located near the
filter; and
a controller (430) adapted to
obtain thresholds associated with each of the plurality of ambient parameters;
compare the fan speed with each of the thresholds; and
output an alarm signal indicative of the clogging if the fan speed exceeds each of the thresholds,
wherein the plurality of ambient parameters comprises two or more of ambient temperature, atmosphere pressure and supply voltage.

7. The device according to claim 6, wherein the fan speed sensor is adapted to obtain an average value of the fan speed over a predetermined time period.

8. The device of claim 6 or 7, wherein the fan speed is represented by Revolutions Per Minute (RPM).

9. The device of claim 6 or 7, wherein the controller is further adapted to compare the fan speed with the threshold for more than once.

10. A filter system, comprising a dust filter, a fan located near the filter and a device for detecting clogging of the filter according to anyone of claims 6-9.

## Patentansprüche

1. Verfahren zum Ermitteln von Verstopfung eines Filters, umfassend:
Erlangen (310) einer Vielzahl von Umgebungsparametern;
für jeden aus der Vielzahl von Umgebungsparametern:
Erlangen (320) einer Vielzahl von Schwellenwerten, die jeweils jedem Umgebungsparameter zugeordnet sind;
Erlangen (330) einer Geschwindigkeit eines Lüfters, der nahe dem Filter angeordnet ist;
Vergleichen (340) der Lüftergeschwindigkeit mit den Schwellenwerten; und
Ausgeben (350) eines Alarmsignals, das auf Verstopfung hinweist, wenn die Lüftergeschwindigkeit jeden der Schwellenwerte überschreitet,
worin die Vielzahl von Umgebungsparametern zwei oder mehr von Folgendem umfasst: Umgebungstemperatur, Atmosphärendruck und Versorgungsspannung.

2. Verfahren nach Anspruch 1, worin das Erlangen der Geschwindigkeit des Lüfters umfasst: Erlangen eines Mittelwerts der Lüftergeschwindigkeit über einen vorbestimmten Zeitraum.

3. Verfahren nach Anspruch 1 oder 2, worin die Lüftergeschwindigkeit durch Umdrehungen pro Minute (RPM) dargestellt wird.

4. Verfahren nach Anspruch 1 oder 2, worin das Erlangen eines Schwellenwerts, der dem Umgebungsparameter zugeordnet ist, umfasst: Abfragen einer Verweistabelle, die vorbestimmte Schwellenwerte für eine Vielzahl von Umgebungsparametern einschließt.

5. Verfahren nach Anspruch 4, worin der vorbestimmte Schwellenwert für einen aus der Vielzahl von Umgebungsparametern aus der Geschwindigkeit des Lüfters abgeleitet wird, der mit einem teilweise verstopften Filter unter dem einen aus der Vielzahl von Umgebungsparametern zusammenarbeitet.

6. Vorrichtung zum Ermitteln von Verstopfung eines Filters, umfassend:
eine Vielzahl von Parametersensoren (410), wobei jeder Sensor dafür eingerichtet ist, einen entsprechenden aus einer Vielzahl von Umgebungsparametern zu erlangen;
einen Lüftergeschwindigkeitssensor (420), der dafür eingerichtet ist, eine Geschwindigkeit eines Lüfters zu erlangen, der nahe dem Filter angeordnet ist; und
einen Controller (430), der dafür eingerichtet ist:
Schwellenwerte zu erlangen, die jedem aus der Vielzahl von Umgebungsparametern zugeordnet sind;
die Lüftergeschwindigkeit mit jedem der Schwellenwerte zu vergleichen; und
ein Alarmsignal auszugeben, das auf Verstopfung hinweist, wenn die Lüftergeschwindigkeit jeden der Schwellenwerte überschreitet,
worin die Vielzahl von Umgebungsparametern zwei oder mehr von Folgendem umfasst: Umgebungstemperatur, Atmosphärendruck und Versorgungsspannung.

7. Vorrichtung nach Anspruch 6, worin Lüftergeschwindigkeitssensor dafür eingerichtet ist, einen Mittelwert der Lüftergeschwindigkeit über einen vorbestimmten Zeitraum zu erlangen.

8. Vorrichtung nach Anspruch 6 oder 7, worin die Lüftergeschwindigkeit durch Umdrehungen pro Minute (RPM) dargestellt wird.

9. Vorrichtung nach Anspruch 6 oder 7, worin der Controller ferner dafür eingerichtet ist, die Lüftergeschwindigkeit mehr als einmal mit dem Schwellenwert zu vergleichen.

10. Filtersystem, umfassend einen Staubfilter, einen nahe dem Staubfilter angeordneten Lüfter und eine Vorrichtung zum Ermitteln von Verstopfung des Filters nach einem der Ansprüche 6 bis 9.

## Revendications

1. Procédé de détection du colmatage d'un filtre, comprenant :
l'obtention (310) d'une pluralité de paramètres ambiants ;
pour chacun de la pluralité de paramètres ambiants :
l'obtention (320) d'une pluralité de seuils respectivement associés à chaque paramètre ambiant ;
l'obtention (330) d'une vitesse d'un ventilateur qui est localisé à proximité du filtre ;
la comparaison (340) de la vitesse de ventilateur avec les seuils ; et
la génération (350) d'un signal d'alarme indiquant le colmatage si la vitesse de ventilateur dépasse chacun des seuils,
la pluralité de paramètres ambiants comprenant deux ou plusieurs des paramètres suivants : température ambiante, pression atmosphérique et tension d'alimentation.

2. Procédé selon la revendication 1, dans lequel l'obtention de la vitesse du ventilateur comprend l'obtention d'une valeur moyenne de la vitesse du ventilateur sur une période prédéterminée.

3. Procédé selon la revendication 1 ou 2, dans lequel la vitesse du ventilateur est indiquée en révolutions par minute (RPM).

4. Procédé selon la revendication 1 ou 2, dans lequel l'obtention d'un seuil associé au paramètre ambiant comprend la récupération d'une table de consultation comprenant des seuils prédéterminés pour une pluralité de paramètres ambiants.

5. Procédé selon la revendication 4, dans lequel le seuil prédéterminé pour un parmi la pluralité de paramètres ambiants est dérivé de la vitesse du ventilateur en interaction avec un filtre partiellement colmaté sous l'un parmi la pluralité de paramètres ambiants.

6. Dispositif de détection de colmatage de filtre, comprenant :
une pluralité de capteurs de paramètres (410), chaque capteur étant conçu pour obtenir un paramètre respectif parmi une pluralité de paramètres ambiants ;
un capteur de vitesse de ventilateur (420) conçu pour obtenir une vitesse de ventilateur, qui est situé près du filtre ; et
un contrôleur (430) conçu pour
obtenir des seuils associés à chacun de la pluralité de paramètres ambiants ;
comparer la vitesse du ventilateur avec chacun des seuils ; et
générer un signal d'alarme indiquant le colmatage si la vitesse du ventilateur dépasse chacun des seuils,
la pluralité de paramètres ambiants comprenant deux paramètres ou plus parmi : la température ambiante, la pression atmosphérique et la tension d'alimentation.

7. Dispositif selon la revendication 6, dans lequel le capteur de vitesse de ventilateur est conçu pour obtenir une valeur moyenne de la vitesse du ventilateur sur une période prédéterminée.

8. Dispositif selon la revendication 6 ou 7, dans lequel la vitesse du ventilateur est indiquée en révolutions par minute (RPM).

9. Dispositif selon la revendication 6 ou 7, dans lequel le contrôleur est en outre conçu pour comparer la vitesse du ventilateur avec le seuil plus d'une fois.

10. Système de filtrage comprenant un filtre à poussière, un ventilateur situé près du filtre et un dispositif de détection de colmatage du filtre selon l'une des revendications 6 à 9.
